# EUROPÄISCHE PATENTSCHRIFT

(11) **EP 1 588 373 B1**
(45) Veröffentlichungstag und Bekanntmachung des Hinweises auf die Patenterteilung: **12.10.2011**
(21) Anmeldenummer: 04700445.2
(22) Anmeldetag: 07.01.2004
(51) Int. Cl.: G11C 11/22

(54) **SCHNELLER REMANENTER RESISTIVER FERROELEKTRISCHER SPEICHER**
FAST REMANENT RESISTIVE FERROELECTRIC MEMORY
MEMOIRE FERROELECTRIQUE RESISTIVE REMANENTE A ACCES RAPIDE

(30) Priorität: 28.01.2003 DE 10303316
(43) Veröffentlichungstag der Anmeldung: 26.10.2005
(60) Teilanmeldung: 10183351.5
(73) Patentinhaber: Forschungszentrum Jülich GmbH, 52425 Jülich (DE)
(72) Erfinder: KOHLSTEDT, Dr. Hermann, 52455 Jülich (DE); MEYER, Dr. René c/o IWE II, RWTH Aachen, 52074 Aachen (DE)
(74) Vertreter: Gille Hrabal Struck Neidlein Prop Roos
(86) Internationale Anmeldenummer: PCT/EP2004/000039
(87) Internationale Veröffentlichungsnummer: WO 2004/068499

(56) Entgegenhaltungen:
- EP-A- 0 657 936
- WO-A-02/43071
- WO-A-02/45172
- US-A- 5 329 485
- US-A- 5 341 325
- US-A- 5 517 445
- US-A- 5 737 180
- US-A- 5 757 042
- US-A- 6 146 906
- US-A1- 2001 007 364
- US-A1- 2002 089 005
- US-B1- 6 344 991
- CONTRERAS J R ET AL: "Memory device based on a ferroelectric tunnel junction" IEEE CONFERENCE PROCEEDINGS, 24. Juni 2002 (2002-06-24), Seiten 97-98, XP010600828
- H. KOHLSTEDT, N.A. PERTSEV, R. WASER: "Size effects on polarization in epitaxial ferroelectric films and the concept of ferroelectric tunnel junctions including first results" MAT. RES. SOC. SYMP. PROCEEDINGS, 2002, Seiten 161-172, XP009029767 USA
- FLEISHER H ET AL: "STORAGE ELEMENT FOR MACHINE USE" IBM TECHNICAL DISCLOSURE BULLETIN, IBM CORP. NEW YORK, US, Bd. 14, Nr. 12, 1. Mai 1972 (1972-05-01), Seiten 3581-3582, XP002039943 ISSN: 0018-8689

## Beschreibung

Die Erfindung betrifft einen Speicher für die elektronische Speicherung von Information sowie ein Verfahren für die Speicherung. Derartige Speicher sind bekannt. Üblicherweise werden derzeit CMOS-basierte, wahlfreie Massenspeicher (SRAM/ DRAM) eingesetzt.

Nach Abschaltung der Versorgungsspannung verliert ein SRAM-oder DRAM-Speicherelement seine Information. Zielsetzung ist die Bereitstellung von Speicherelementen, die auch nach Abschaltung einer Versorgungsspannung ihren Speicherinhalt behalten.

Unter wahlfreiem Massenspeicher ist zu verstehen, dass hier die Information nicht sequenziell aus den einzelnen Speicherelementen ausgelesen werden muss, wie dies z. B. bei einer Festplatte der Fall ist. Es kann also in einem solchen Massenspeicher, der viele einzelne Speicherelemente aufweist eine ausgewähltes Speicherelement gezielt beschrieben und/ oder ausgelesen werden.

Um einen Speicherinhalt auch nach Abschaltung einer Versorgungsspannung behalten zu können, werden sogenannte FLASH-Speicherelemente verwendet. Ein FLASH-Speicherelement umfasst einen CMOS-Transistor. Der Transistor weist ein sogenanntes FLOATING-Gate auf. Hierunter ist ein Gate zu verstehen, welches zunächst nicht elektrisch mit seiner Umgebung verbunden ist. Durch einen Tunnelprozess wird Ladung an das FLOATING-Gate weitergeleitet. Der Tunnelprozess wird durch Anlegung einer sehr hohen Spannung in Gang gesetzt. Anschließend kann die im FLOATING-Gate befindliche Ladung nicht mehr abfließen. Die Information bleibt also unabhängig davon gespeichert, ob eine Versorgungsspannung anliegt oder nicht.

Problematisch ist die hohe Spannung. Ferner dauert es relativ lange, bis ein FLASH-Speicherelement beschrieben ist. Die Zahl der Schreibzyklen ist relativ gering.

Zielsetzung ist, die Speicherfähigkeiten eines FLASH-Speicherelements mit den schnellen Lese- und Schreibzeiten zu kombinieren, die beim eingangserwähnten SRAM-Speicherelement möglich sind.

Zur Erreichung dieses Ziels sind FeRAM sowie MRAM-Speicherelemente entwickelt worden.

Ein FeRAM-Speicherlelement ist wie folgt aufgebaut. Beispielsweise gibt es eine Schicht aus ferroelektrischem Material. Zu beiden Seiten wird diese Schicht mit Elektroden kontaktiert. Das ferroelektrische Material weist eine Polarisationsrichtung auf, die durch Anlegung einer Spannung an die Elektroden umgeklappt werden kann. Die Spannung muss hierfür die geeignete Polarität und die geeignete Größe aufweisen. Es wird also die Koerzitivspannung angelegt, um das Umklappen der Polarisation zu bewirken. Die Richtung der Polarisation entspricht der digital gespeicherten Information (0 oder 1).

Um die Information auszulesen, wird eine Spannung angelegt, die groß genug ist, um die Polarisationsrichtung umklappen zu lassen. Klappt die Polarisationsrichtung um, so fließt kurzzeitig eine entsprechend große Ladung. Die Ladungsmenge wird durch Messen der Spannungsänderung über einem Kondensator bestimmt. Ist eine solche Spannungsänderung registriert worden, so wird damit festgestellt, dass die Polarisationsrichtung umgeklappt ist. Damit ist klar, dass der Polarisationszustand vor Anlegung der Spannung entsprechend umgekehrt vorlag. Fließt bei Anlegen entsprechenden Spannung lediglich eine sehr kleine Ladungsmenge, so ist damit ermittelt worden, dass kein Umklappprozess statt gefunden hat. Damit ist ebenfalls die Polarisationsrichtung ermittelt und somit der gespeicherte Zustand ausgelesen worden.

Bei Verkleinerung der Fläche des FeRAM-Speicherelements verringert sich die Ladungsmenge, was zu Problemen bei der Miniaturisierung führt.

Wird beim Auslesen durch Anlegen einer Koerzitivspannung die Polarisation umgeklappt, ist damit die abgespeicherte Information geändert worden. In diesem Fall muss nach dem Auslesen der Information diese erneut in der entsprechenden Speicherzelle abgespeichert werden. Nachteilhaft kann bei einem FeRAM-Speicherelement der Speicherinhalt also nicht zerstörungsfrei ausgelesen.

Erneutes Einlesen einer Information kostet Zeit. Entsprechend werden Schreib- und Lesezeiten bei einem FeRAM-Speicherelement reduziert. Ferner wird Strom für das erneute Einschreiben benötigt. Dies ist ebenfalls nachteilhaft.

Ein FeRAM-Speicherelement weist darüber hinaus den Nachteil auf, im Laufe der Zeit erstens eine gespeicherte Information zu verlieren und zweitens überhaupt die Fähigkeit zu verlieren, Informationen zu speichern.

Um ein schnelles Speicherelement bereit zu stellen, welches nach Abschaltung der Versorgungsspannung seine Information behält, gibt es darüber hinaus sogenannte MRAM-Speicherelemente. Bei einem MRAM-Speicherelement ist eine hartmagnetische Schicht mit vorgegebener Magnetisierungsrichtung durch einen Tunnelkontakt von einer weichmagnetischen Schicht getrennt. Die Magnetisierungsrichtung der weichmagnetischen Schicht kann durch Anlegen eines geeigneten magnetischen Feldes umgeklappt werden. Das Magnetfeld wird durch einen elektrischen Strom erzeugt. Der elektrische Widerstand des Tunnelkontakts hängt davon ab, ob die Magnetisierungsrichtung in der weichmagnetischen Schicht parallel oder antiparallel zur Magnetisierungsrichtung in der hartmagnetischen Schicht steht. Die Information wird also durch Ermittlung eines elektrischen Widerstandes ausgelesen, der durch den Tunnelkontakt gebildet wird. Ein MRAM-Speicherelement ist daher ein sogenanntes resistives Speicherelement. Der Informationsgehalt wird also durch Ermittlung eines elektrischen Widerstandes ermittelt. Hiervon zu unterscheiden sind die vorgenannten Speicherelemente, so zum Beispiel das FeRAM-Speicherelement. Hierbei handelt es sich um ein so genanntes ladungsbasiertes Speicherelement.

Resistive Speicherelemente sind ladungsbasierten Speicherelementen grundsätzlich überlegen. So können resistive Speicherelemente einfacher miniaturisiert werden.

Nachteilhaft tritt bei einem MRAM-Speicherelement ein deutliches Übersprechen beim Einschreiben der Information auf. Hierunter ist zu verstehen, dass bei Einschreiben einer Information benachbarte Speicherelemente in einem Massenspeicher beeinflusst werden und möglicherweise hier unerwünscht Information geändert wird. Nachteilhaft ist, dass ein Tunnelkontakt erzeugt werden muss, der relativ große Produktionskosten verursacht. Mit Zunahme der Schaltzyklen kommt es zu einer unerwünschten Drehung der Magnetisierung im Hartmagneten. Dies führt zum Ausfall der Speicherzelle.

Aus der Druckschrift EP 0 657 936 A1 ist ein Speicherelement mit mehreren permanenten Schaltzuständen bekannt. Das Speicherelement umfasst eine zwischen zwei Elektroden befindliche nicht leitende dielektrische Schicht sowie eine bei Raumtemperatur aus ferroelektrischem Material bestehende Schicht mit einer permanenten Polarisation. Mit Hilfe eines Spannungspulses wird ein Speicherzustand geändert. Das Speicherelement wird durch eine Strommessung ausgelesen.

Die Druckschrift WO 02/43071 A1 offenbart ein Verfahren nebst Vorrichtung zur elektronischen Speicherung von Information. Indem in ein Speicherelement eine Information durch Ausrichten einer Polarisation in einer polarisierbaren Schicht geschrieben wird und die Information mittels einer Strom-Spannungskennilnie nicht destruktiv gelesen wird.

Aus der Druckschrift WO 02/43071 geht ein ferroelektrisches Speicherelement mit einer Elektrode und Gegenelektrode hervor. An die Elektrode grenzt eine ferroelektrische Schicht. An die ferroelektrische Schicht grenzt eine Schicht aus nichtferroelektrischem Material.

Aufgabe der Erfindung ist die Schaffung eines schnellen, remanenten Speichers für die Speicherung digitaler information sowie die Bereitstellung eines zugehörigen Verfahrens.

Die Aufgabe wird durch ein Verfahren mit den Merkmalen des Anspruchs 1 sowie durch ein Speicherelement mit den Merkmalen des Anspruchs 2 gelöst. Vorteilhafte Ausgestaltungen ergeben sich aus den Unteransprüchen.

Das Speicherelement der erfindungsgemäßen Art ist wie folgt aufgebaut:
Ein Speicherelement wird von beiden Seiten von einer Elektrode kontaktiert. Das eigentliche Speicherelement umfasst wenigstens eine ferroelektrische Schicht und eine daran angrenzende nicht ferroelektrische Schicht. Eine Elektrode kontaktiert dann die ferroelektrische Schicht und die andere Elektrode die nicht-ferroelektrische Schicht. Anstelle der nicht ferroelektrischen Schicht kann auch eine hinreichend schwach ferroelektrische Schicht verwendet werden, um die erfindungsgemäße Wirkung zu erzielen.
Die Information wird geschrieben, indem die Polarisationsrichtung in der ferroelektrischen Schicht in die entsprechende Richtung geklappt wird. Die eine Polarisationsrichtung entspricht der "1"-Information. Die andere Polarisationsrichtung entspricht der "0"-Information.

Die Polarisationsrichtung wird in die gewünschte Richtung geklappt, indem eine entsprechende Spannung an den beiden Elektroden angelegt wird. Die Spannung muss hierfür geeignet groß sein und die geeignete Richtung aufweisen.

Da die Information geschrieben wird, indem eine Spannung angelegt wird, tritt nicht das Problem des Übersprechens wie beim MRAM-Speicherelement auf.

Der elektrische Widerstand, der von der nicht-ferroelektrischen und der ferroelektrischen Schicht gebildet wird, hängt von der Polarisationsrichtung in der ferroelektrischen Schicht ab. Zum Auslesen des Speicherelementes wird an die Elektroden z. B. eine Spannung angelegt und der Stromfluss gemessen. Der so oder anders ermittelte elektrische Widerstand stellt ein Maß für die Polarisationsrichtung und damit ein Maß für die abgespeicherte Information dar.

Im Unterschied zu FeRAM-Speicherelementen wird die Information also resistiv und damit zerstörungsfrei ausgelesen. Die Information bleibt also auch nach dem Auslesen erhalten. Eine ausgelesene Information braucht nicht erneut abgespeichert zu werden, Hieraus ergeben sich gegenüber einem FeRAM-Speicherelement Geschwindigkeitsvorteile.

Wird das erfindungsgemäße Speicherelement verkleinert, so verändert sich zwar der Widerstand. Es kann jedoch beim erfindungsgemäßen Bauelement durch Veränderung der Leitfähigkeit der verwendeten Materialien und/oder die Wahl geeigneter Elektroden der Widerstand bei Verkleinerung des Speicherelements so angepasst werden, dass der Widerstandsunterschied in Abhängigkeit von der Polarisationsrichtung ermittelt werden kann. Eine Verkleinerung der Bauelemente der erfindungsgemäßen Art ist also im Vergleich zu FeRAM-Speicherelementen unproblematisch möglich.

Unproblematisch kann die Widerstandsänderung, die mit einer Änderung der Polarisationsrichtung Im ferroelektrischen Material verbunden ist, einen Faktor 2 und mehr betragen. Es ist sogar möglich, Widerstandsänderungen zu erzielen, die sich um das 10-bis 100-fache und mehr unterscheiden. Es bereifet daher keine Probleme, eine Information auszulesen.

Es hat sich ferner herausgestellt, das bautechnlsche StöreInflüsse bel FeRAM-Speicherelementen beim erfindungsgemäßen Speicherelement nicht auftreten bzw. sogar positiv genutzt werden.

Um das erfindungsgemäße Speicherelement bel hohen Frequenzen betreiben zu können, Ist ein kleiner elektrischer Widerstand erforderlich. Es Ist daher Im Unterschied zu FeRAM-Speicherelementen hier von Vorteil, wenn der elektrische Widerstand der ferroelektrischen und nicht-ferroelektrischen Schicht klein Ist. Ein elektrischer Widerstand im Sinne der Erfindung Ist klein, wenn mit hohen Taktfrequenzen ausgelesen werden kann. Die möglichen Taktfrequenzen liegen dann Insbesondere bei 100 MHz und mehr. Mit anderen Worten: Ist es nicht möglich, ein erfindungsgemäßes Speicherelement mit Frequenzen oberhalb von 100 MHz auszulesen, so liegt kein kleiner Widerstand im Sinne der Erfindung vor.

Als Materiallen für die Bereltstellung der ferroelektrischen Schicht werden ferroelektrische Anorganika, insbesondere Oxyde mit Perowskit- oder perowskitöhnlichen Struktur oder ferroelektrische Polymere bevorzugt. Möglich sind ferner ferroelektrische Flüssigkristalle. Soll ein Speicherelement der erfindungsgemäßen Art besonders preiswert bereit gestellt werden, so werden ferroelektrische Polymere bevorzugt. Soll ein erfindungsgemäßes Speicherelement bereit gestellt werden, welches besonders schnell Ist, also bei dem besonders schnell Informationen eingeschrieben und/ oder ausgelesen werden können, so werden ferroelektrische Oxyde bevorzugt, Beispiele für besonders vorteilhafte ferroelektrische Oxyde sind PbZrₓTi₁₋ₓO₃, Ba₁₋ₓSrₓTiO₃ wie BaTiO₃, SrBi₂Ta₂O₉, KₓWO₃ sowie Bi₄ Ti₃O₁₂. Um zu einer besonders guten Langzeltstabilität zu gelangen, werden PbZrₓTi₁₋ₓO₃ sowie SrBi₂Ta₂O₉ besonders bevorzugt. Beispiele für besonders vorteilhafte ferroelektrische Polymere sind PVDF, PVDF-TFE, [CH₂CF₂]ₙ. PVDF Ist besonders zu bevorzugen. Hieraus lassen sich besonders gut Speicher für flexible Anwendungen, z.B. biegsame Chipkarten oder Smartcards, herstellen.

Sollen ganz besonders schnelle Speicherelemente der erfindungsgemäßem Art bereit gestellt werden, so wird als Material für die ferroelektrische Schicht sogenannte Nieder- □- Ferroelektrika gewählt. Die Dielektrizitätskonstante □ ist klein, wenn □ kleiner als 100 ist.

Als ferroelektrische Materialien eignen sich Verbindungen mit einer Perowskit- oder perowskitähnlichen Struktur, wie z.B.,

| | |
|---|---|
| PbZrₓTi₁₋ₓO₃ (PZT) Langzeitstabilität | *Beispiel für besonders gute |
| SrBi₂ Ta₂O₉ (SBT) Langzeitstabilität | *Beispiel für besonders gute |
| Ba₁₋ₓSrₓTiO₃ | |
| Ba₁₋ₓPbₓTiO₃ | |

ferroelektrische Niobat-Kristalle der Formel PbNb₂O₆,
ferroelektrische Kristalle mit Wolfram-Bronze Struktur der Formel KₓWO₃ und NaₓWO₃ mit x< 1,
ferroelektrische Kristalle wie z.B. Bi₄Ti₃O₁₂, Gd₂(MoO₄), Pb₅Ge₃O₁₁ oder
Verbindungen der KTiOPO₄-Famille oder
ferroelektrische Halbleiter (SbSl-Familie) sowie
organische Ferroelektrika, beispielweise Polymere: Polyvinyliden Fluoride (PVDF)
Polyvinyliden Fluorid-Trifluoroethylene (PVDF-TFE) Cynopolymere
Ungeradzahilge Nylons
(CH₂CF₂)ₙ mit n > = 1
wasserlösliche ferroelektrische Kristalle der KH₂PO₄- Famllle (KDP) oder
(NH₂CH₂COOH)₃ x H₂SO₄ - Familie (TGS),

Es wird ein besonders schnelles Bauelement bzw. Speicherelement der erfindungsgemäßen Art bereit gestellt, indem als nicht-ferroelektrisches Material dotiertes SrTiO₃ verwendet wird. Als Dotlermaterial sind besonders gut La, Nb geeignet.

Die nicht-ferroelektrische Schicht sollte In einer Ausführungsform der Erfindung wenigstens einen 1 Å dick sein. Besonders bevorzugt sind Dicken von wenigstens einem Nanometer. Dicken oberhalb von 20 nm können von Vorteil sein. Die ferroelektrische Schicht sollte wenigstens einen Nanometer dick sein. Besonders bevorzugt sind Dicken von wenigstens 10 Nanometer. Das gesamte Speicherelement ohne die Elektroden sollte insgesamt nicht dicker als 5 µm, besonders bevorzugt nicht dicker als 500 Nanometer, ganz besonders bevorzugt nicht dicker als 200 Nanometer sein.

Je dünner die nicht-ferroelektrische Schicht ist, desto kleiner ist die Widerstandsänderung, die durch Umklappen der Polarisation herbeigeführt wird. Andererseits sind zugleich entsprechend schnellere Ausiesezeiten möglich. Soll also ein Speicherelement der erfindungsgemäßen Art bereit gestellt werden, bei dem besonders schnelle Auslesezelten möglich sind, so Ist die nicht-ferroelektrische Schicht relativ dünn. Eine nicht-ferroelektrische Schicht Ist Insbesondere dann dünn, wenn diese dünner Ist als die ferroelektrische Schicht. Sie Ist ferner dünn, wenn die Dicke weniger als 30 Nanometer, bevorzugt weniger als 5 Nanometer beträgt. Besonders bevorzugt ist die nicht ferroelektrische Schicht wenigstens zweifach dünner als die ferroelektrische Schicht.

Bei der ferroelektrischen Schicht verhält es sich ähnlich. Je dünner die ferroelektrische Schicht ist, desto kleiner ist die damit verbundene Widerstandsänderung, die durch Umklappen der Polarisation herbeigeführt wird. Jedoch sind mit kleineren ferroelektrischen Schichtdicken schnellere Auslesezeiten möglich. Soll also ein Bauelement bzw. Speicherelement mit besonders schnellen Auslesezelten bereit gestelit werden, so Ist die Schichtdicke der ferroelektrischen Schicht klein. Eine Schichtdicke der ferroelektrischen Schicht ist insbesondere klein, wenn der Wert von 30 Nanometern unterschritten wird. Die Schichtdicke ist ferner Insbesondere dann klein, wenn diese kleiner Ist als die Schichtdicke der nicht-ferroelektrischen Schicht.

In einer weiteren Ausführungsform sind sowohl die ferroelektrische als auch die nicht ferroelektrische Schicht dünn.

Große Widerstandsänderungen sind von Interesse, wenn die information besonders zuverlässig auslesbar sein soll, das Bauelement Innerhalb großer Temperaturbereiche einsetzbar und/ oder gegenüber Strahlung unempfindlich sein soll.

In einer weiteren Ausführungsform der Erfindung wird die ferroelektrische Schicht beidseitig von einer nicht-ferroelektrischen Schicht kontaktiert. In diesem Fall Ist eine Mindestspannung erforderlich, damit eine Widerstandsänderung beim Umklappen der Polarisation eintritt. Aufgrund der Mindestspannung, die erforderlich Ist, wenn beidseitig nicht-ferroelektrisch leitende Schichten vorgesehen werden, Ist die erstgenannte Ausführungsform jedoch zu bevorzugen.

Als Material der Elektroden sind solche Materialien zu bevorzugen, die einen geringeren Kontaktwiderstand mit den angrenzenden Schichten des Spelcherelements aufweisen. Geringe Kontaktwiderstände können durch ein geringes Kontaktpotentlal oder durch einen Tunnelkontakt bereitgesteilt werden. Ein Kontaktpotential Ist gering, wenn die Austrittsarbeit des Materials der Elektrode, die Insbesondere aus einem Metall bestehen kann, und die Elektronenaffinität der Schicht um weniger als 0,5 Elektronenvolt differiert. Viele Metalle welsen eine geeignete Austrittsarbeit auf, Daneben kommen elektrisch leitende oxydische Elektroden in Betracht. Oxydische Elektroden sind vorteilhaft, weil die Leitfähigkeit des Kontaktes/der Kontakte besser eingesteilt werden kann. Durch die Einstellung können die gewünschten Eigenschaften des Speicherelementes bereit gestellt werden.

Oxydische Elektroden werden dann bevorzugt, wenn diese an Oxyde angrenzen,

Das erfindungsgemäße Bauelement ist in einer Ausführungsform auf einem Substrat aufgebracht. Auf dem Substrat befindet sich dann die untere Elektrode. Hieran grenzt zunächst die ferroelektrische Schicht und darüber die nlcht-ferroelektrische Schicht (oder umgekehrt) an. Darüber befindet sich die sogenannte TOP-Elektrode. Diese besteht zweckmäßlgerwelse aus Metall, da die Fertigung dann besonders einfach Ist. Die untere Elektrode, auch BOTTOM-Elektrode genannt, besteht zweckmäßlgerweise aus oxydischem Material. Diese kann jedoch auch aus Metall bestehen.

In einer weiteren Ausführungsform der Erfindung wird bevorzugt die TOP-Elektrode von einer nicht-ferroelektrischen Schicht begrenzt. Dies eröffnet relativ große Wahlmögllchkelten In Bezug auf die eingesetzten Materialien. So kann auf den Jeweiligen Anwendungsfall abgestimmt ein Speicherelement mit entsprechend optimierten Eigenschaften bereitgestellt werden.

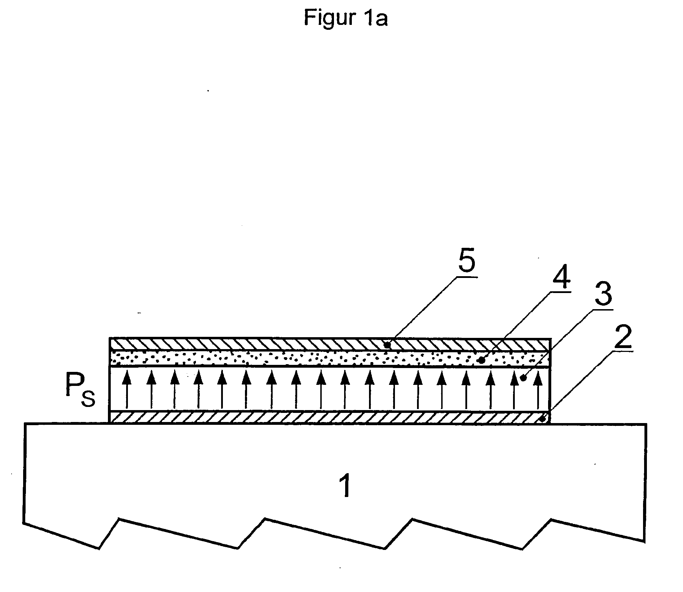

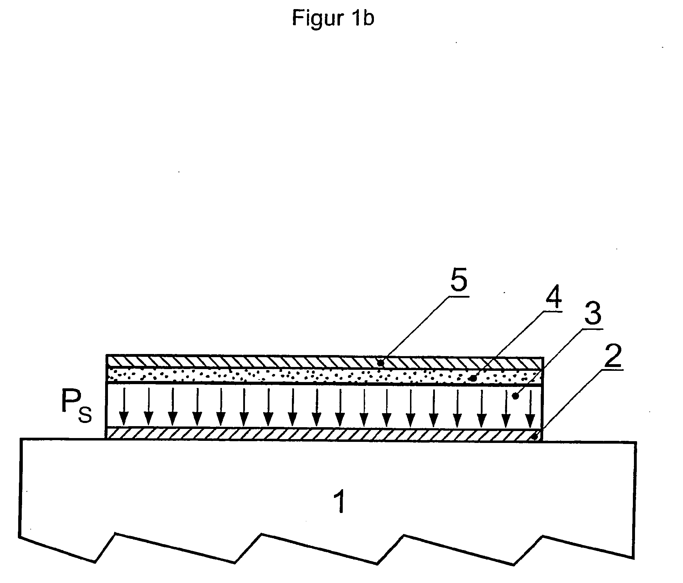

In diesem Fall (Figur 1) kann die nicht- [oder schwach-) ferroelektrische Schicht kalt abgeschieden werden. Es ist also möglich, halbleitende Materialien abzuscheiden. Falls die nicht-ferroelektrische Schicht an die Topelektrode angrenzt, werden dadurch die Aufwachsbedlngungen für die ferroelektrische Schicht nicht negativ beeinflusst.

In einer vorteilhaften Ausgestaltung der Erfindung sind die nicht-ferroelektrische Schicht und/oder die ferroelektrische Schicht dotiert. Hierdurch wird die Leitfähigkeit eingesteilt und die Langzeitstabllltät des erfindungsgemäßen Bauelements gesteigert.

Die ferroelektrische Schicht ist im Fall von Oxyden bevorzugt einkristallin oder kolumnar. Sie kann jedoch auch polykristallin sein. Werden Polymere eingesetzt, so ist eine polykristalline Struktur zu bevorzugen. Folgende Vorteile werden durch die Wahl der jeweiligen Struktur erzielt. In Oxyden ist die Herstellung kolumnarer Schichten mit hoher remanenter Polarisation einfacher als die Herstellung einkristalliner Schichten (besonders kostengünstig). Weiterhin lässt sich über die Mlkrostruktur das Schaltverhalten und der Wert der remanenten Polarisation beeinflussen.

Wird die Polarisation in der ferroelektrischen Schicht nur teilweise umgeschaltet, so können nicht nur "0" oder "1" Informationen abgespeichert werden sondern auch Zwischenzustände. Die Speicherdichte erhöht sich entsprechend. Vorteilhaft sind kolumnare Schichten vorzusehen. Eine kolumnare Schicht Ist also zu bevorzugen, wenn eine besonders hohe Speicherdichte bereit gestellt werden soll. Es handelt sich hier um ein säulenartige Struktur, bel denen die Säulen von einer Elektrode In Richtung der anderen Elektrode weisen. Jede Säule ist einkristallin aufgebaut. Zwischen den einzelnen Säulen existiert beispielsweise eine kristallographische Versetzung.

Um die verschledenen unterschiedlichen Polarisationszustände zwecks Erzielung einer großen Speicherdichte zu erreichen, ist es erforderlich, eine definierte Ladungsmenge für das Schreiben vorzusehen. Er wird also Strom in definierter Menge zugeführt.

Vorteile unterschiedlicher Dotierungen:
Schwach dotiert: hohe Widerstandsänderung, hoher Widerstand -> besonders sicher und stromsparend
Hoch dotlert: geringer Widerstand, kleinere Widerstandsänderung - > sehr schnell, stark miniaturisierbar

Bei oxydischen Schichten ist eine Dotierung mit Donatoren besonders geeignet, da diese die Dichte von schwach beweglichen Gitterfehistellen Im Oxyd verringert, wodurch die Zyklenzahl und die Langzeltstabllltät des Speicherelements deutlich verbessert wird.

Besonders günstlge Donatoren sind aufgrund Ihrer Valenzstabilität La und Nb.

Die ferroelektrische Schicht ist bevorzugt dicker als die nicht forroelektrische Schicht, wenn große Widerstandsänderungen aus vorgenannten Gründen erwünscht sind. Die Speicherung und das Auslesen von Information gelingt so besonders zuverlässig.

### Ausführungsbeispiel

In der Figur 1 a,b wird Im Schnitt ein Substrat 1 gezeigt, auf dem sich eine Bottom-Elektrode 2 befindet. Diese besteht aus einem elektrisch leitenden, oxydischen Material. Auf der Bottom-Elektrode ist eine kolumnare Schicht 3 aus ferroelektrischem Material aufgebracht. Hierüber befindet sich eine Schicht 4 aus nicht ferroelektrischem Material. Zuletzt endet der Aufbau des Spelcherelements mit der Top-Elektrode 5.

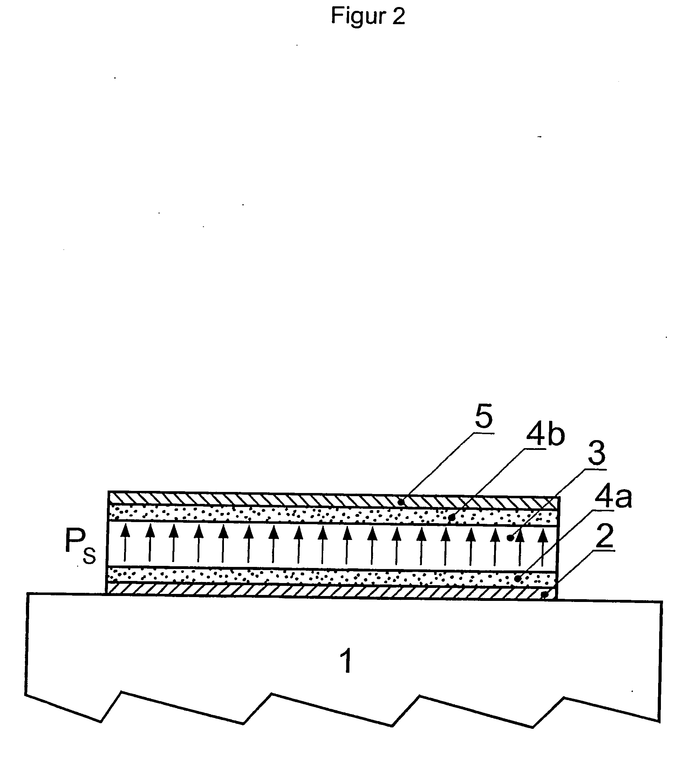

Fig. 2 zeigt ein weiteres Ausführungsbeispiel mit zwei nicht ferroelektrischen Schichten 4a und 4b.

## Patentansprüche

1. Verfahren für die elektronische Speicherung von Informationen, Indem In ein Speicherelement, bestehend aus einer Elektrode (2), einer hieran angrenzenden ferroelektrischen Schicht (3), einer an die ferroelektrische Schicht (3) angrenzende Schicht (4) aus nicht ferroelektrischem Material sowie eine an die Schicht (4) aus nicht ferroelektrischem Material angrenzende Elektrode (5), eine Information durch Ausrichten einer Polarisation in der polarisierbaren Ferroelektrischen Schicht geschrieben wird und die Information geiesen wird, indem die Polarisationsrichtung durch eine Wlderstandsmessung ermittelt wird, **dadurch gekennzeichnet, dass** die Schicht (4) aus nicht ferroelektrischem Material aus dotiertem SrTiO₃ besteht.

2. Speicherelement für die Durchführung des Verfahrens nach Anspruch 1, bestehend aus einer Elektrode (2), einer hieran angrenzenden ferroelektrischen Schicht (3), einer an die ferroelektrische Schicht (3) angrenzenden Schicht (4) aus nicht ferroelektrischem Material sowie eine an die Schicht (4) aus nicht ferroelektrischem Material angrenzende Elektrode (5), wobei der elektrische Widerstand, der von der nicht-ferroelektrischen und der ferroelektrischen Schicht gebildet wird, von der Polarisationsrichtung In der ferroelektrischen Schicht abhängt und zum Auslesen des Speicherelements Mittel zur Messung des Widerstands vorhanden sind,
**dadurch gekennzeichnet, dass**
die Schicht (4) aus nicht ferroelektrischem Material aus dotiertem SrTiO₃ besteht.

3. Speicherelement nach Anspruch 2, bei dem die nicht-ferroelektrische Schicht wenigstens 1 Angström, bevorzugt wenigstens ein Nanometer dick ist.

4. Speicherelement nach Anspruch 2 oder 3, bel dem die ferroelektrische Schicht wenigstens 1 Nanometer, bevorzugt wenigstens 10 Nanometer dick Ist.

5. Speicherelement nach einem der Ansprüche 2 bis 4, bei dem die ferroelektrische Schicht und die nicht ferroelektrische Schicht zusammen nicht dicker als 5 µm, bevorzugt nicht dicker als 500 nm sind.

## Claims

1. A process for electronically storing information by writing, into a storage element consisting of an electrode (2), a ferroelectric layer (3) adjacent thereto, a layer (4) of non-ferroelectric material adjacent to the ferroelectric layer (3), as well as an electrode (5) adjacent to layer (4) of non-ferroelectric material, an information by aligning a polarisation in the polarisable ferroelectric layer and by reading the information by identifying the direction of polarisation by resistance measurement, **characterised in that** the layer (4) of non-ferroelectric material consists of doped SrTiO₃.

2. A storage element for realisation of the process according to claim 1 consisting of an electrode (2), a ferroelectric layer (3) adjacent thereto, a layer (4) of non-ferroelectric material adjacent to the ferroelectric layer (3), as well as an electrode (5) adjacent to layer (4) of non-ferroelectric material, wherein the electric resistance formed by the non-ferroelectric layer and the ferroelectric layer depends on the direction of polarisation in the ferroelectric layer and means for resistance measurement are present to read data in the storage element,
**characterised in that**
the layer (4) of non-ferroelectric material consists of doped SrTiO₃.

3. The storage element according to claim 2 wherein the non-ferroelectric layer is at least 1 A preferably at least 1 nm of thickness.

4. The storage element according to claim 2 or 3 wherein the ferroelectric layer is at least 1 nm preferably at least 10 nm of thickness.

5. The storage element according to one of claims 2 to 4 wherein the ferroelectric layer and the non-ferroelectric layer are not more than 5 µm preferably not more than 500 nm of thickness.

## Revendications

1. Procédé pour l'enregistrement électronique des informations par écrire, dans un élément d'enregistrement consistant en une électrode (2), une couche ferroélectrique (3) adjacente à celle-ci, une couche (4) consistant en un matériau non-ferroélectrique adjacente à la couche ferroélectrique (3), ainsi qu'une électrode (5) adjacente à la couche (4) consistant en un matériau non-ferroélectrique, une information par l'alignement d'une polarisation dans la couche ferroélectrique polarisable et par lire l'information par déterminer la direction de polarisation en mesurant la résistance, **caractérisé par le fait que** la couche (4) de matériau non-ferroélectrique consiste en SrTiO₃ doté.

2. Elément d'enregistrement pour la mise en oeuvre le procédé selon la revendication 1 consistant en une électrode (2), une couche ferroélectrique (3) adjacente à celle-ci, une couche (4) consistant en un matériau non-ferroélectrique adjacente à la couche ferroélectrique (3), ainsi qu'une électrode (5) adjacente à la couche (4) consistant en un matériau non-ferroélectrique, dans lequel la résistance électrique formée par la couche non-ferroélectrique et la couche ferroélectrique dépend de la direction de polarisation dans la couche ferroélectrique et des moyens pour mesurer la résistance sont présents pour lire des données dans l'élément d'enregistrement,
**caractérise par le fait que**
la couche (4) de matériau non-ferroélectrique consiste en SrTiO₃ doté.

3. Elément d'enregistrement selon la revendication 2 dans lequel la couche non-ferroélectrique a une épaisseur d'au moins 1 A préférablement d'au moins 1 nm.

4. Elément d'enregistrement selon la revendication 2 or 3 dans lequel la couche ferroélectrique a une épaisseur d'au moins 1 nm préférablement d'au moins 10 nm.

5. Elément d'enregistrement selon l'une des revendications 2 à 4, dans lequel la couche ferroélectrique et la couche non-ferroélectrique ont une épaisseur de ne pas plus de 5 µm préférablement de ne pas plus de 500 nm.
